# EUROPEAN PATENT APPLICATION

(11) **EP 4 148 777 A1**
(43) Date of publication of application: **15.03.2023**
(21) Application number: 22195330.0
(22) Date of filing: 13.09.2022
(51) Int. Cl.: H01L 23/31, H01L 23/485, H01L 23/48, H01L 23/49

(54) **SEMICONDUCTOR DEVICE**

(30) Priority: 14.09.2021 JP 2021149048; 17.08.2022 JP 2022130035
(71) Applicant: KABUSHIKI KAISHA TOSHIBA, Minato-ku Tokyo 105-0023 (JP)
(72) Inventor: Hsu, Yuchen, Tokyo, 105-0023 (JP); Uchida, Masayuki, Tokyo, 105-0023 (JP); Iguchi, Tomohiro, Tokyo, 105-0023 (JP)
(74) Representative: Hoffmann Eitle

(57) **Abstract**

A semiconductor device (1) includes a semiconductor part (10), first and second electrodes (20, 30), and first and second protective films (40, 50). The first electrode (20) is provided on the semiconductor part (10). The first protective film (40) is provided on the semiconductor part (10) and covers an outer edge (20e) of the first electrode (20). The second electrode (30) is provided on the first electrode (20). The second electrode (30) includes an outer edge (30e) partially covering the first protective film (40). The second protective film (50) is provided on the semiconductor part (10) and covers the first protective film (40) and the outer edge (30e) of the second electrode (30).

## Description

### FIELD

Embodiments relate to a semiconductor device.

### BACKGROUND

In a power control module, a semiconductor chip is preferably mounted using a copper wire of low electrical resistance. However, copper is harder than aluminum, silver or the like, and the copper wire may generate bonding damage in the semiconductor chip.

### BRIEF DESCRIPTION OF THE DRAWINGS

FIGS. 1A and 1B are schematic views showing a semiconductor device according to an embodiment;
FIGS. 2A to 3C are schematic cross-sectional views showing manufacturing processes of the semiconductor device according to the embodiment;
FIGS. 4A and 4B are schematic plan views showing the semiconductor device according to the embodiment;
FIGS. 5A and 5B are perspective views schematically showing methods for mounting the semiconductor device according to the embodiment;
FIGS. 6A to 6C are schematic views showing another method for mounting the semiconductor device according to the embodiment;
FIG. 7 is a schematic cross-sectional view showing a power module according to the embodiment; and
FIGS. 8A and 8B are schematic views showing a semiconductor device according to a modification of the embodiment.

### DETAILED DESCRIPTION

According to one embodiment, a semiconductor device includes a semiconductor part, first and second electrodes, and first and second protective films. The first electrode is provided on the semiconductor part. The first protective film is provided on the semiconductor part and covers an outer edge of the first electrode. The second electrode is provided on the first electrode. The second electrode includes an outer edge partially covering the first protective film. The second protective film is provided on the semiconductor part and covers the first protective film and the outer edge of the second electrode.

Embodiments will now be described with reference to the drawings. The same portions inside the drawings are marked with the same numerals; a detailed description is omitted as appropriate; and the different portions are described. The drawings are schematic or conceptual; and the relationships between the thicknesses and widths of portions, the proportions of sizes between portions, etc., are not necessarily the same as the actual values thereof. The dimensions and/or the proportions may be illustrated differently between the drawings, even in the case where the same portion is illustrated.

There are cases where the dispositions of the components are described using the directions of XYZ axes shown in the drawings. The X-axis, the Y-axis, and the Z-axis are orthogonal to each other. Hereinbelow, the directions of the X-axis, the Y-axis, and the Z-axis are described as an X-direction, a Y-direction, and a Z-direction. Also, there are cases where the Z-direction is described as upward and the direction opposite to the Z-direction is described as downward.

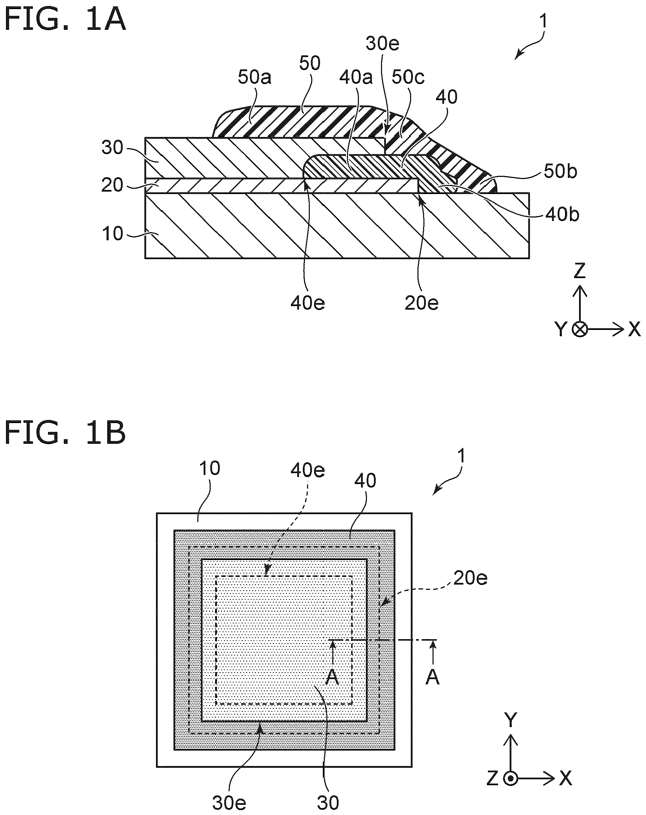

FIGS. 1A and 1B are schematic views showing a semiconductor device 1 according to an embodiment. FIG. 1A is a cross-sectional view along line A-A shown in FIG. 1B. FIG. 1B is a plan view showing the upper surface of the semiconductor device 1. The semiconductor device 1 is, for example, a switching element such as a MOSFET, an IGBT (Insulated Gate Bipolar Transistor), a Schottky diode, etc.

As shown in FIG. 1A, the semiconductor device 1 includes a semiconductor part 10, a first electrode 20, a second electrode 30, a first protective film 40, and a second protective film 50. The semiconductor part 10 includes, for example, silicon, silicon carbide, gallium nitride, etc.

The first electrode 20 is provided on a front surface of the semiconductor part 10 and is electrically connected to an active region (not illustrated) of the semiconductor part 10. The first electrode 20 includes, for example, aluminum. The first electrode 20 is, for example, a source electrode of a MOSFET. Or, the first electrode 20 is an emitter electrode of an IGBT or an anode electrode of a Schottky diode.

The second electrode 30 is provided on the first electrode 20. The second electrode 30 contacts the first electrode 20 and is electrically connected to the first electrode 20. The second electrode 30 includes a material having a higher hardness than the material of the first electrode 20. The second electrode 30 includes, for example, copper (Cu). The second electrode 30 is thicker than the first electrode 20 in a direction, e.g., a Z-direction, perpendicular to the front surface of the semiconductor part 10. Thereby, the semiconductor part 10 can reduced the impact applied thereto when bonding, for example, a copper wire to the second electrode 30; and it is possible to prevent the bonding damage.

The first protective film 40 is provided on the semiconductor part 10 to cover an outer edge 20e of the first electrode 20. The first protective film 40 includes, for example, a first resin that is insulative. The first protective film 40 includes, for example, polyimide. For example, the first protective film 40 covers, and protects from the outside air, the outer perimeter part of the first electrode 20 and the outer edge of the contact surface between the semiconductor part 10 and the first electrode 20.

The first protective film 40 includes a first part 40a covering the outer edge 20e of the first electrode 20, and a second part 40b contacting the front surface of the semiconductor part 10. The first part 40a and the second part 40b are provided as a continuous body. The first part 40a extends between the first electrode 20 and the second electrode 30.

The second protective film 50 is provided on the semiconductor part 10 to cover the first protective film 40 and an outer edge 30e of the second electrode 30. The second protective film 50 includes, for example, a second resin that is insulative. The second resin of the second protective film 50 may include the same component as the first resin of the first protective film 40. The second protective film 50 includes, for example, polyimide. The second resin may be a resin different from the first resin.

The second protective film 50 includes, for example, a first part 50a, a second part 50b, and a third part 50c. The first part 50a contacts a front surface of the second electrode 30 and extends along the front surface of the second electrode 30. The first part 50a extends inward from the outer edge 30e of the second electrode 30. For example, the first part 50a extends over the part at which the first part 40a of the first protective film 40 extends between the first electrode 20 and the second electrode 30; and the first part 50a covers the part at which the first electrode 20 and the second electrode 30 contact. The second part 50b contacts the front surface of the semiconductor part 10. The third part 50c covers the first protective film 40 between the first part 50a and the second part 50b. The first part 50a, the second part 50b, and the third part 50c of the second protective film 50 are provided as a continuous body.

The second protective film 50 doubly protects the contact surface between the semiconductor part 10 and the first electrode 20. Also, the second protective film 50 prevents delamination of the second electrode 30 from the first protective film 40 starting from the outer edge 30e of the second electrode 30.

For example, the close contact between the first protective film 40 and the second electrode 30 is not very secure because the first protective film 40 includes a resin. When operating the semiconductor device 1, stress is generated between the first protective film 40 and the second electrode 30 due to the linear thermal expansion coefficient difference thereof. When the second protective film 50 is not provided, there is a risk that the adhesion between the first protective film 40 and the second electrode 30 may degrade, and the second electrode 30 lifts up from the outer edge. Furthermore, the temperature rise and temperature drop that are repeated when operating the semiconductor device 1 may cause separation of the interface between the first electrode 20 and the second electrode 30. Such a discrepancy degrades the reliability of the semiconductor device 1.

In the semiconductor device 1 according to the embodiment, the delamination of the outer edge 30e of the second electrode 30 from the first protective film 40 can be prevented by providing the second protective film 50. Also, the reliability of the semiconductor device 1 can be further improved by the first and second protective films 40 and 50 including resins having high moisture resistance. For example, it is preferable for the second protective film 50 to include a resin having a higher moisture resistance than the first protective film 40.

FIG. 1B shows the second electrode 30 and the first protective film 40. In FIG. 1B, the outer edge 20e of the first electrode 20 and an inner edge 40e of the first protective film 40 (see FIG. 1A) each are illustrated by broken lines. The second protective film 50 is not illustrated in FIG. 1B.

As shown in FIG. 1B, the second electrode 30 is provided inward of the first electrode 20 in a plan view parallel to the front surface of the semiconductor part 10. In other words, the outer edge 30e of the second electrode 30 is positioned inward of the outer edge 20e of the first electrode 20. For example, the X-direction width of the first electrode 20 is greater than the X-direction width of the second electrode 30. The Y-direction width of the first electrode 20 is greater than the Y-direction width of the second electrode 30.

As shown in FIG. 1B, the first protective film 40 surrounds the first electrode 20 along the outer edge 20e of the first electrode 20. The first protective film 40 surrounds the second electrode 30 along the outer edge of the second electrode 30.

Thus, by providing the second electrode 30 further inward than the first electrode 20, the creepage distance from the front surface of the semiconductor part 10 to the outer edge 30e of the second electrode 30 via the surface of the first protective film 40 can be lengthened. The breakdown voltage of the semiconductor device 1 can be increased thereby. The breakdown voltage of the semiconductor device 1 can be further improved by providing the second protective film 50 that covers the first protective film 40 and the outer edge 30e of the second electrode 30.

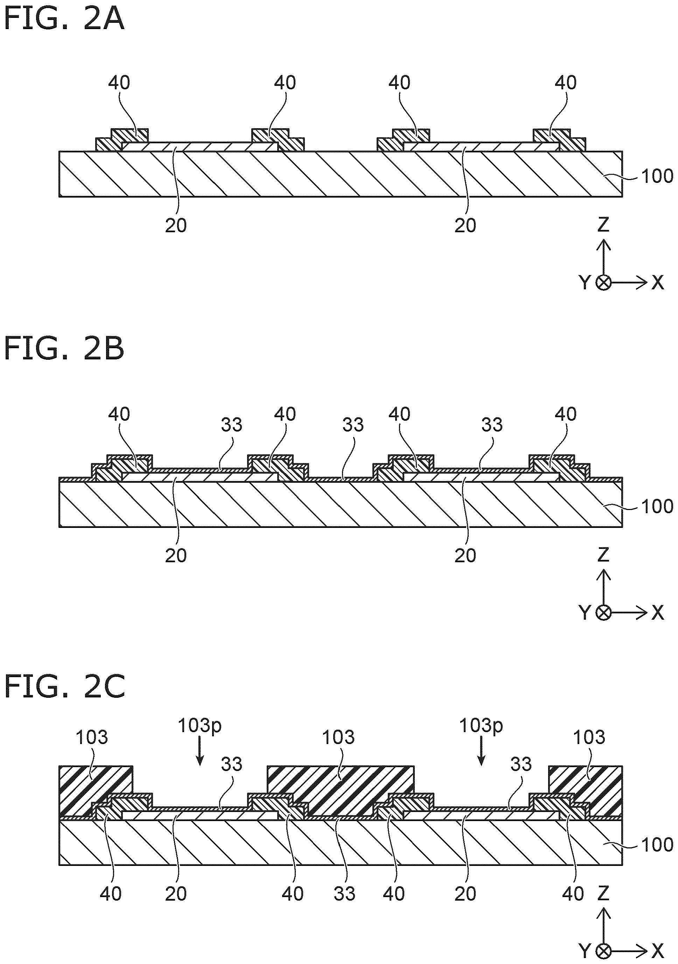

A method for manufacturing the semiconductor device 1 will now be described with reference to FIGS. 2A to 3C. FIGS. 2A to 3C are schematic cross-sectional views showing manufacturing processes of the semiconductor device 1 according to the embodiment.

As shown in FIG. 2A, a wafer 100 is prepared such that the first electrode 20 and the first protective film 40 are provided on the front surface of the wafer 100. The first protective film 40 is provided on the wafer 100 to cover the outer edge of the first electrode 20.

An active region (not illustrated) of the semiconductor device 1 is provided directly under the first electrode 20. When the semiconductor device 1 is a MOSFET, a drain electrode (not illustrated) is provided at the backside of the wafer 100. When the semiconductor device 1 is an IGBT or a Schottky diode, a collector electrode or a cathode electrode (not illustrated) is provided at the backside of the wafer 100.

For example, the wafer 100 can be diced into multiple semiconductor devices 1 in the state shown in FIG. 2A. In such a case, the first electrode 20, e.g., an aluminum electrode, is exposed at the front surface of the semiconductor device 1. For example, an aluminum wire is bonded on the first electrode 20 when mounting the semiconductor device 1.

According to the embodiment as shown in FIG. 2B, a metal layer 33 is provided on the front surface of the wafer 100. The metal layer 33 covers the first electrode 20 and the first protective film 40. The metal layer 33 includes, for example, nickel.

As shown in FIG. 2C, a resist mask 103 is formed on the metal layer 33. The resist mask 103 has an opening 103p positioned above the first electrode 20. The resist mask 103 partially covers the first protective film 40 and covers the front surface of the wafer 100 between adjacent first protective films 40.

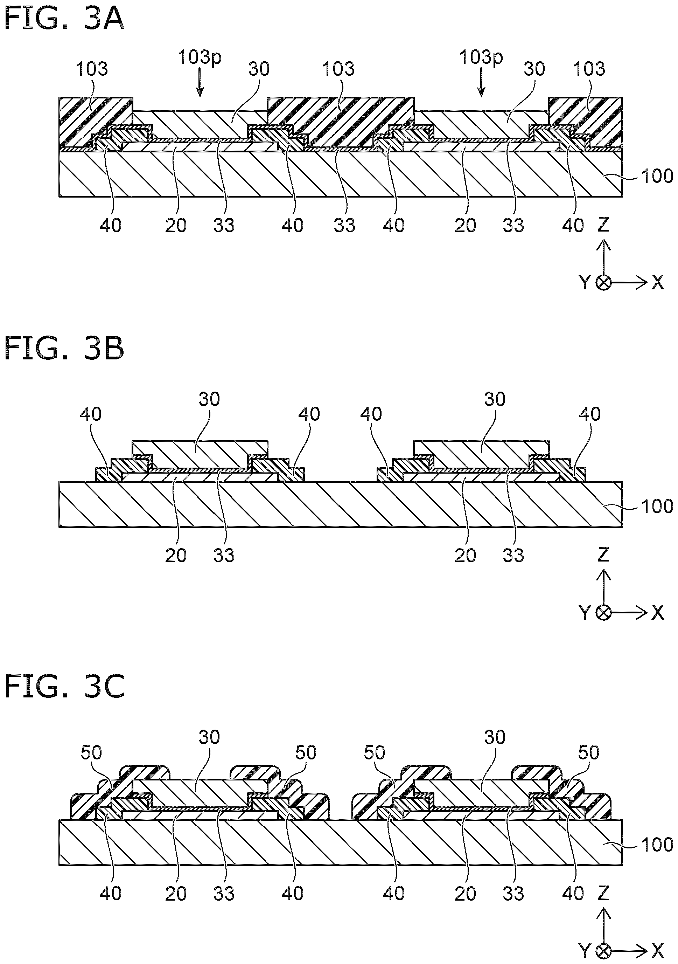

As shown in FIG. 3A, the second electrode 30 is formed inside the opening 103p of the resist mask 103. For example, the second electrode 30 is formed using electroplating via the metal layer 33. The second electrode 30 includes, for example, copper (Cu). The second electrode 30 juts onto the first protective film 40.

As shown in FIG. 3B, the front surface of the wafer 100 and a portion of the first protective film 40 are exposed by removing the resist mask 103 and an exposed portion of the metal layer 33. For example, the resist mask 103 and the metal layer 33 are removed by wet etching. The exposed portion of the metal layer 33 are removed after removing the resist mask 103.

As shown in FIG. 3C, the second protective film 50 is formed on the front surface of the wafer 100. The second protective film 50 covers the first protective film 40 and the outer edge of the second electrode 30. For example, the second protective film 50 is formed by selectively removing a film-shaped resin formed on the front side of the wafer 100. Continuing, the semiconductor device 1 is diced by cutting the wafer 100 using, for example, a dicing blade.

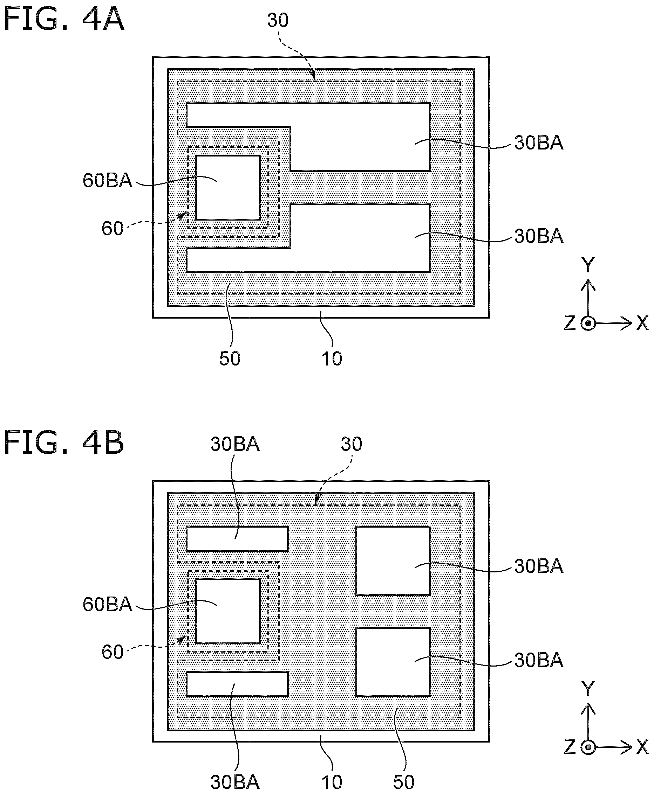

FIGS. 4A and 4B are schematic plan views showing the semiconductor device 1 according to the embodiment. FIGS. 4A and 4B are plan views illustrating the front side of the semiconductor part 10. In the example, the semiconductor device 1 is, for example, a MOSFET or an IGBT that includes a gate electrode.

As shown in FIG. 4A, the front side of the semiconductor part 10 is covered with the second protective film 50; and portions of the second electrode 30 (see FIGS. 1A and 1B) and a control pad 60 are exposed. The control pad 60 is electrically connected to the gate electrode (not illustrated).

The second protective film 50 is provided to expose a bonding area 30BA of the second electrode 30 to which a metal wire is bonded. The second protective film 50 also is provided so that a bonding area 60BA of the control pad 60 is exposed. Thus, the bonding areas 30BA and 60BA each have an exposed area sufficient for bonding the metal wires; and the second protective film 50 preferably covers the second electrode 30 and the control pad 60 as much as possible.

In the example shown in FIG. 4B, the second protective film 50 is provided to expose four bonding areas 30BA of the second electrode 30. Thus, the exposed area is reduced in the bonding areas 30BA, and the second protective film 50 covers a wider surface area.

The second protective film 50 effectively suppresses the delamination of the second electrode 30 from the first protective film 40. The second protective film 50 prevents the penetration of moisture and the like from the outside air, and increases the breakdown voltage of the semiconductor device 1.

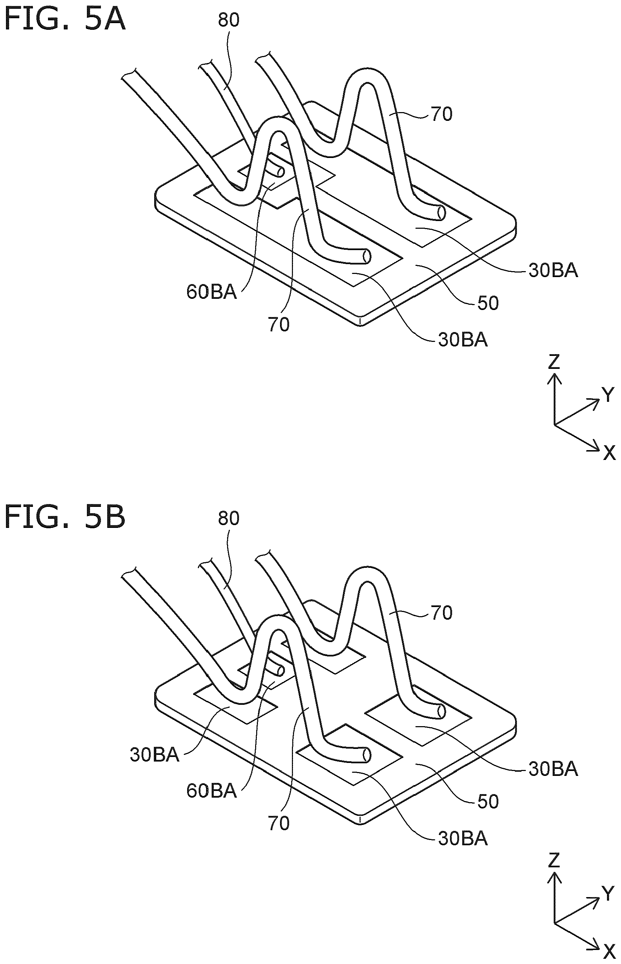

FIGS. 5A and 5B are perspective views schematically showing methods for mounting the semiconductor device 1 according to the embodiment. FIGS. 5A and 5B illustrate a metal wire 70 and a metal wire 80 that are bonded to the second electrode 30 and the control electrode 60, respectively.

As shown in FIG. 5A, multiple metal wires 70 are bonded on the second electrode 30. For example, the metal wires 70 each are bonded by providing looping to connect to the second electrode 30 at two locations. The metal wires 70 are connected on the bonding areas 30BA of the second electrode 30. In the example, one metal wire 70 is connected to the second electrode 30 at two connection positions in the one bonding area 30BA.

The metal wire 80 is bonded on the bonding area 60BA of the control pad 60 (see FIGS. 4A and 4B). The metal wire 80 is, for example, a copper wire. The metal wire 80 may be, for example, an aluminum wire.

In the example shown in FIG. 5B, one metal wire 70 is connected to two bonding areas 30BA. There is one bonding position on each bonding area 30BA.

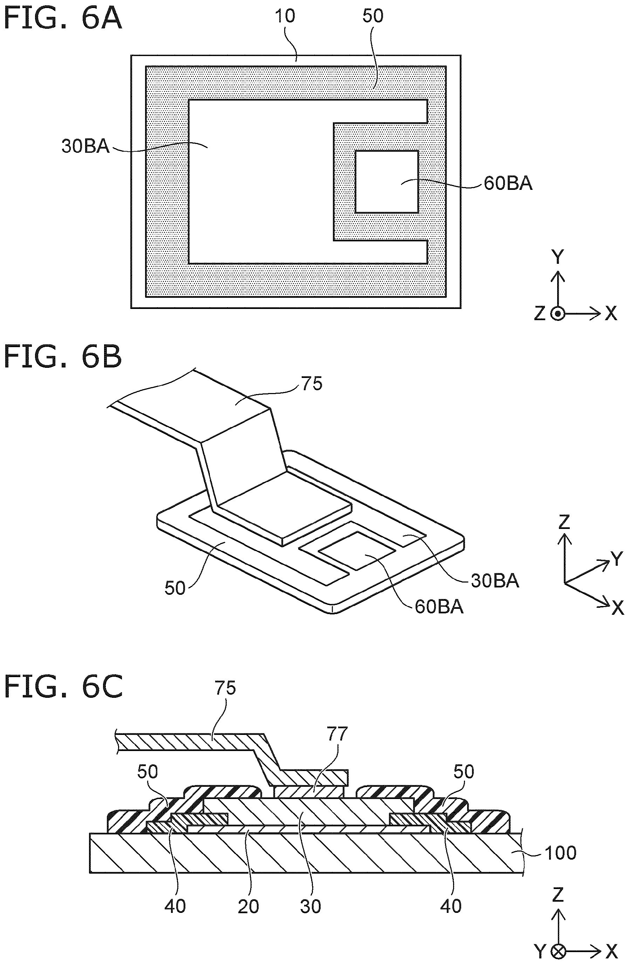

FIGS. 6A and 6B are schematic views showing another method for mounting the semiconductor device 1 according to the embodiment. FIG. 6A is a plan view illustrating the front side of the semiconductor part 10. FIG. 6B is a perspective view showing a metal connector 75 bonded on the second electrode 30. FIG. 6C is a cross-sectional view showing the bonding structure.

As shown in FIG. 6A, the second protective film 50 is provided to expose one bonding area 30BA of the second electrode 30 and the bonding area 60BA of the control pad 60.

As shown in FIG. 6B, for example, the plate-shaped metal connector 75 is connected to the second electrode 30 in the bonding area 30BA. The metal connector 75 is, for example, a metal plate that includes copper. The bonding area 30BA has a surface area suited to the size of the connection surface of the metal connector 75. Such a metal connector 75 has a large current capacity and a low electrical resistance value. In other words, the metal connector 75 is suited to applications in which a large current flows. The metal connector 75 is not limited to one shown in the example. The metal connector 75 may be a block-like metal member. Moreover, the metal connector 75 may have an aspect ratio of 1.5 to 6.0 in a cross-section perpendicular to the longitudinal direction, but the embodiment is not limited thereto.

On the other hand, for example, the metal wire 80 (see FIGS. 5A and 5B) is connected to the bonding area 60BA of the control pad 60.

As shown in FIG. 6C, the metal connector 75 is connected to the second electrode 30 via a connection member 77. The connection member 77 is, for example, a solder material. The connection member 77 may be a sintered material that includes silver, copper or the like.

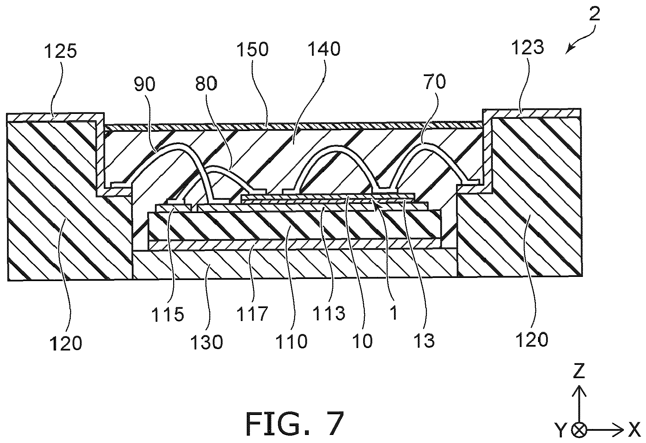

FIG. 7 is a schematic cross-sectional view showing a power module 2 according to the embodiment. The power module 2 is, for example, a power converter in which the semiconductor device 1 is embedded.

For example, the semiconductor device 1 is mounted on the front surface of a DBC (Direct Bonded Copper) substrate 110 that is provided inside a case 120. The DBC substrate 110 includes a mount pad 113 and a control interconnect 115. The mount pad 113 and the control interconnect 115 are, for example, copper foil.

The semiconductor device 1 is mounted with the backside toward the mount pad 113. For example, the electrode at the backside of the semiconductor device 1 is electrically connected to the mount pad 113 via a die mount material 13 that is conductive.

For example, the DBC substrate 110 is mounted on a base plate 130 via a solder material 117. The solder material 117 connects the base plate 130 and the back surface of the DBC substrate 110. The base plate 130 is, for example, a metal plate. When operating the semiconductor device 1, the generated heat is externally dissipated via the DBC substrate 110 and the base plate 130.

The case 120 surrounds the DBC substrate 110 and the base plate 130 on which the semiconductor device 1 is mounted. The bottom of the case 120 contacts the base plate 130.

The case 120 includes connection terminals 123 and 125. The semiconductor device 1 provided inside the case 120 is electrically connected to the external circuit via the connection terminals 123 and 125. For example, the connection terminal 123 is electrically connected to the second electrode 30 of the semiconductor device 1 via the metal wire 70. For example, the connection terminal 125 is electrically connected to the mount pad 113 of the DBC substrate 110 via a metal wire 90. In other words, the connection terminal 125 is electrically connected to the electrode at the backside of the semiconductor device 1 via the metal wire 90 and the mount pad 113.

For example, the control pad 60 of the semiconductor device 1 (see FIGS. 4A and 4B) is electrically connected to the control interconnect 115 of the DBC substrate 110 via the metal wire 80. The control interconnect 115 is electrically connected to a signal terminal (not illustrated) provided in the case 120.

The semiconductor device 1 that is mounted on the DBC substrate 110 is immersed in, for example, a gel-like insulating member 140 filled into the space surrounded with the case 120 and the base plate 130. The space that is surrounded with the case 120 and the base plate 130 is sealed by a lid 150 connected to the upper end of the case 120.

In the power module 2, a large current flows between the connection terminal 123 and the connection terminal 125. Therefore, the reliability of the electrical connections between the semiconductor device 1 and the connection terminal 123 and between the mount pad 113 and the connection terminal 125 are increased by using, for example, copper wires as the metal wires 70 and 90. The plate-shaped or block-shaped metal connector 75 may be used instead of the metal wire 70.

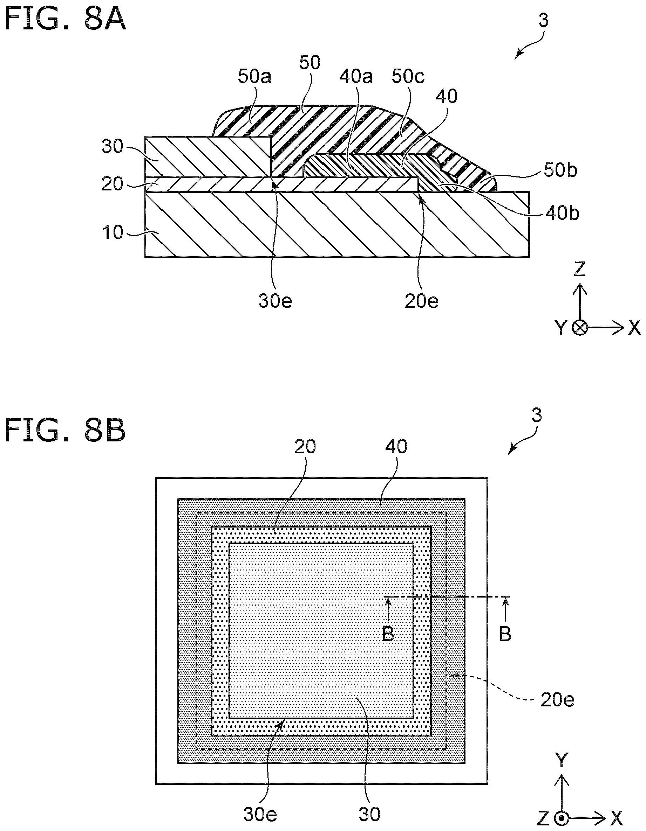

FIGS. 8A and 8B are schematic views showing a semiconductor device 3 according to a modification of the embodiment. FIG. 8A is a cross-sectional view along line B-B shown in FIG. 8B. FIG. 8B is a plan view showing the front side of the semiconductor part 10.

As shown in FIG. 8A, the semiconductor device 3 includes the semiconductor part 10, the first electrode 20, the second electrode 30, the first protective film 40, and the second protective film 50. The first electrode 20 is provided on the front surface of the semiconductor part 10. The second electrode 30 is provided on the first electrode 20.

The first protective film 40 covers the outer edge 20e of the first electrode 20 on the semiconductor part 10. The first protective film 40 includes the first part 40a covering the outer edge 20e of the first electrode 20, and the second part 40b contacting the front surface of the semiconductor part 10. The first part 40a and the second part 40b are provided as a continuous body.

The second protective film 50 is provided on the semiconductor part 10 to cover the first protective film 40 and the outer edge 30e of the second electrode 30. The second protective film 50 includes, for example, the first part 50a, the second part 50b, and the third part 50c. The first part 50a contacts the front surface of the second electrode 30 and extends along the front surface of the second electrode 30 inward from the outer edge 30e of the second electrode 30. The second part 50b contacts the front surface of the semiconductor part 10. The third part 50c covers the first protective film 40 between the first part 50a and the second part 50b. The first part 50a, the second part 50b, and the third part 50c of the second protective film 50 are provided as a continuous body. The second protective film 50 doubly protects the contact surface between the semiconductor part 10 and the first electrode 20.

In the example, the second electrode 30 is provided on the first electrode 20 so that the outer edge 30e is apart from the first protective film 40. The second protective film 50 covers the front surface of the first electrode 20 exposed between the first protective film 40 and the second electrode 30.

FIG. 8B shows the first electrode 20, the second electrode 30, and the first protective film 40. The outer edge 20e of the first electrode 20 is illustrated by a broken line in FIG. 8B. The second protective film 50 is not illustrated in FIG. 8B.

As shown in FIG. 8B, the second electrode 30 is provided inward of the first electrode 20 in a plan view parallel to the front surface of the semiconductor part 10. In other words, the outer edge 30e of the second electrode 30 is positioned inward of the outer edge 20e of the first electrode 20. For example, the X-direction width of the first electrode 20 is greater than the X-direction width of the second electrode 30. The Y-direction width of the first electrode 20 is greater than the Y-direction width of the second electrode 30.

As shown in FIG. 8B, the first protective film 40 surrounds the first electrode 20 along the outer edge 20e of the first electrode 20. The first protective film 40 is apart from the outer edge 30e of the second electrode 30 and surrounds the second electrode 30. The front surface of the first electrode 20 is exposed between the second electrode 30 and the first protective film 40.

In the semiconductor device 3, the creepage distance from the front surface of the semiconductor part 10 to the outer edge 30e of the second electrode 30 via the surface of the first protective film 40 is longer, and the breakdown voltage can be increased. The breakdown voltage can be further increased by the second protective film 50 covering the outer edge 30e of the second electrode 30 and the exposed front surfaces of the first protective film 40 and the first electrode 20.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A semiconductor device (1), comprising:
a semiconductor part (10);
a first electrode (20) provided on the semiconductor part;
a first protective film (40) provided on the semiconductor part (10), the first protective film (40) covering an outer edge (20e) of the first electrode (20);
a second electrode (30) provided on the first electrode (20), the second electrode (30) including an outer edge (30e) partially covering the first protective film (40); and
a second protective film (50) provided on the semiconductor part (10), the second protective film (50) covering the first protective film (40) and the outer edge (20e) of the second electrode (20).

2. The device (1) according to claim 1, wherein
the second electrode (30) includes at least one bonding area (30BA) surrounded with the second protective film (50).

3. The device (1) according to claim 2, wherein
the second electrode (30) includes a plurality of the bonding areas (30BA).

4. The device according to claim 1, wherein
the outer edge (30e) of the second electrode (30) is positioned inward of the outer edge (20e) of the first electrode (20) in a plan view parallel to a front surface of the semiconductor part (10) facing the first electrode (20).

5. The device (1) according to claim 1, wherein
the first protective film (40) is provided with a frame shape and extends along the outer edge (20e) of the first electrode (20),
the first protective film (40) including an outer edge and an inner edge (40e), the outer edge contacting the semiconductor part (10), the inner edge (40e) contacting the first electrode (20), the inner edge (40e) being positioned further inward than the outer edge (20e) of the second electrode (20) in a plan view parallel to a front surface of the semiconductor part (10) facing the first electrode (20).

6. The device (1) according to claim 5, wherein
the second protective film (50) is provided with a frame shape and extends along the outer edge (30e) of the second electrode (30), the second protective film (50) including an outer edge and an inner edge, the outer edge contacting the semiconductor part (10), the inner edge contacting the second electrode (30);
the inner edge of the second protective film (50) is positioned inward of the inner edge (40e) of the first protective film (40) in the plan view parallel to the front surface of the semiconductor part (10); and
the outer edge of the second protective film (50) is positioned outward of the outer edge of the first protective film (40).

7. The device (1) according to claim 1, wherein
the semiconductor part (10) includes silicon carbide.

8. The device (1) according to claim 1, wherein
the second electrode (30) has a hardness greater than a hardness of the first electrode (20).

9. The device (1) according to claim 8, wherein
the first electrode (20) includes aluminum, and the second electrode (30) includes copper.

10. The device (1) according to claim 1, wherein
the second protective film (50) extends inward from the outer edge (30e) of the second electrode (30) along a front surface of the second electrode (30), and
the second protective film (50) partially covers a contact portion of the second electrode (30) at which the second electrode (30) contacts the first electrode (20).

11. The device (1) according to claim 1, wherein
the first protective film (40) includes a first resin, and the second protective film (50) includes a second resin.

12. The device (1) according to claim 11, wherein
the second resin includes a component same as a component of the first resin.

13. The device (2) according to claim 1, further comprising:
a terminal (123) electrically connected to the second electrode (30),
the second electrode (30) and the terminal (123) being connected by a plurality of metal wires (70).

14. The device (2) according to claim 1, further comprising:
a terminal (123) electrically connected to the second electrode (30),
the second electrode (30) and the terminal (123) being connected by a metal connector (75).

15. The device (2) according to claim 14, wherein
the metal connector (75) is connected to the second electrode (30) via a conductive connection member (77).
